# EUROPEAN PATENT APPLICATION

(11) **EP 0 893 861 A2**
(43) Date of publication of application: **27.01.1999**
(21) Application number: 98305664.9
(22) Date of filing: 16.07.1998
(51) Int. Cl.: H01S 3/025, H01S 3/25, G02B 6/42

(54) **Optical module**

(30) Priority: 25.07.1997 JP 200261/97; 25.07.1997 JP 200262/97; 25.07.1997 JP 200263/97; 27.02.1998 JP 47463/98
(71) Applicant: Oki Electric Industry Co., Ltd., Tokyo (JP)
(72) Inventor: Shibuya, Yoshiki, 7-12, Toranomon 1-chome, Minato-ku Tokyo (JP); Mineo, Naoyuki, 7-12, Toranomon 1-chome, Minato-ku Tokyo (JP); Sakai, Shunji, 7-12, Toranomon 1-chome, Minato-ku Tokyo (JP)
(74) Representative: Read, Matthew Charles

(57) **Abstract**

The object of the present invention is to provide a compactified optical module (10; 40; 50; 70; 180; 200; 220; 230). The light receiving module according to the present invention is a light receiving module comprising an optical element (16; 184; 204), current control section (18; 186; 206), and holding section (12, 14; 42, 44; 52, 54), on which the optical element and current control section are provided, wherein the holding sections, comprise a first surface and a second surface located in a plane intersecting with the plane containing the first surface, and the optical element is provided on the first surface and the current control section is provided on the second surface.

## Description

### BACKGROUND OF THE INVENTION

### Field of the Invention

This invention relates to an optical module used in optical communications, and the like.

### Description of the Related Art

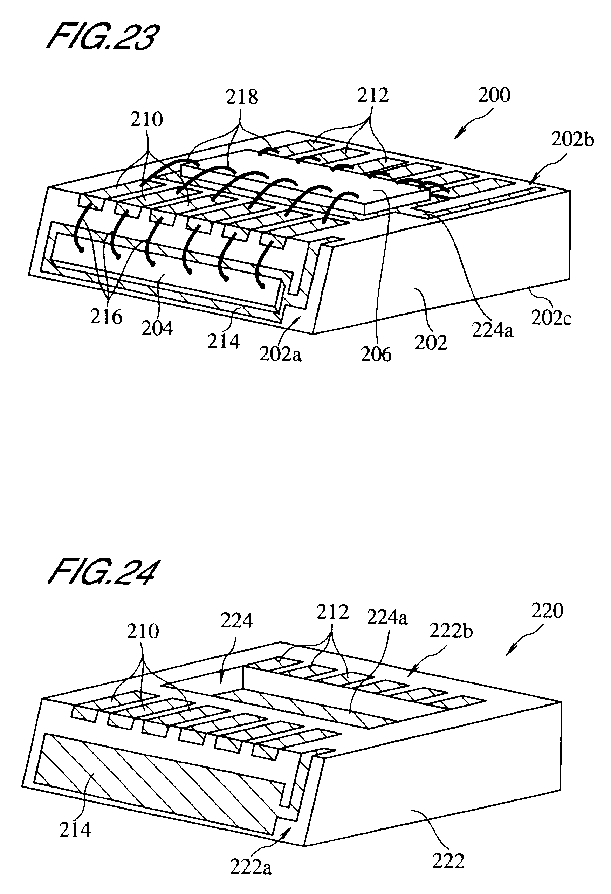

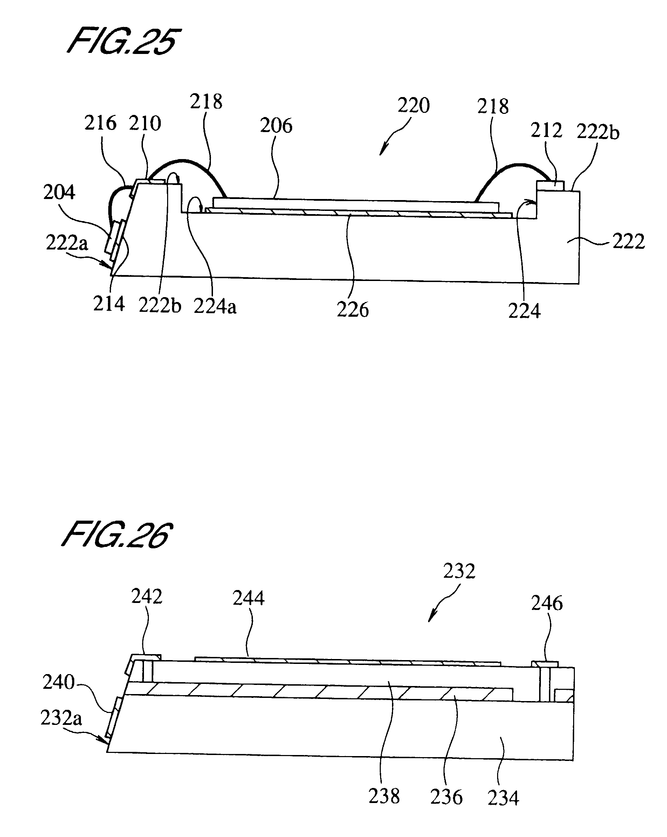

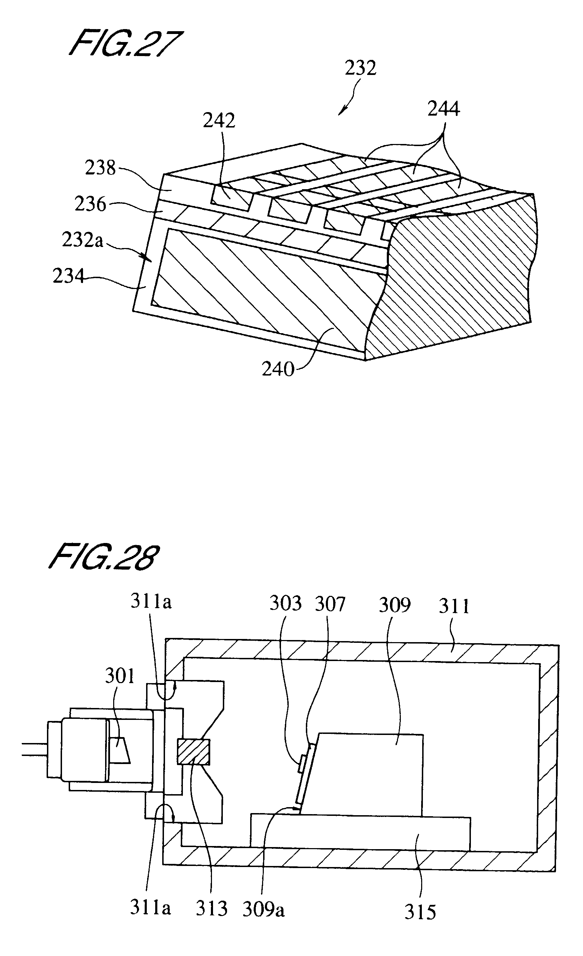

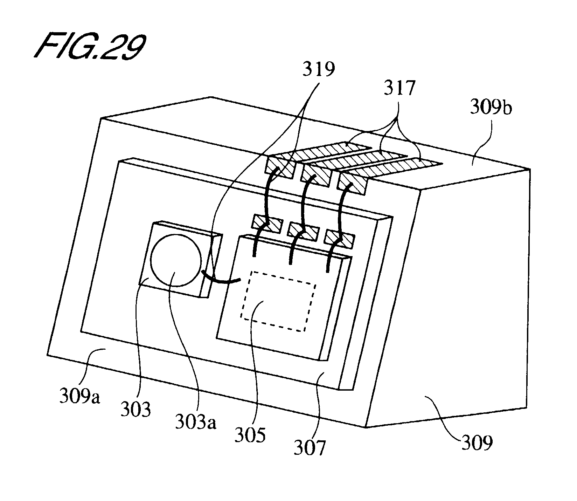

An example of an optical module for optical communications is the light receiving module described in the reference (1991 Autumn Conference of Electronic Information Communications Association, B-652, "Broadband Receiver Module for 10 Gbit/s Optical Transmission", Keiichi Kitamura, et. al.). A light receiving module of this type will be described with reference to Fig. 28 and Fig. 29.

Fig. 28 is a cross-sectional view of a light receiving module cut in the direction of the light emitted from an optical fiber. Fig. 29 is a perspective view giving a schematic illustration of a structure of a light receiving module fixed in a casing.

As shown in Figs. 28 and 29, the light receiving module comprises a light receiving element 303 for receiving light from an optical fiber 301; an amplifier (amp) 305 for amplifying the light receiving current converted by the light receiving element 303; a substrate 307 on which the light receiving element 303 and amp 305 are mounted; a holding unit 309 (carrier) on which the substrate 307 is fixed; and a casing 311 enclosing the carrier 309.

A window section 311a is provided in the case 311 for introducing light from an optical fiber 301 into the case 311. A lens 313 for focusing light from the optical fiber 301 is fixed in the window section 311a (Fig. 28). The amp 305 has a structure such that it is formed into an IC and incorporated into a semiconductor substrate of Si, or the like, and in the present specification, the whole structure including this substrate is called the `amp'.

The light receiving element 303 and amp 305 are fixed by soldering to the same surface of a ceramic substrate 307. The ceramic substrate 307 is fixed by soldering to a side 309a of a carrier 309 made of ceramic (Fig. 28). Moreover, the carrier 309 is also fixed by soldering to the case 311. A spacer 315 is provided between the carrier 309 and the case 311 in order to align the light-receiving section 303a of the light receiving element 303 mounted on the carrier 309 with the vertical position of the light input to the case by the optical fiber 301 (Fig. 28). Therefore, the light receiving module is constructed such that light emitted from the end section of the optical fiber 301 is focused by the lens 313 and arrives at the light-receiving section 303a of the light receiving element 303 positioned in the case 311.

A wiring pattern 317 is formed by metal plating onto the upper surface 309b of the carrier 309. The light receiving element 303 and the amp 305, and the amp 305 and the wiring pattern 317, are electrically connected by means of respective wires 319 (Fig. 29).

The light receiving module is thus composed such that a light receiving current converted from light by the light receiving element 303 is amplified and voltage-converted by the amp 305 and can be output externally from the case as an output voltage.

The size of optical elements, such as light receiving elements, is approximately 0.5 mm square, and the size of a current controlling section, such as the amp, is approximately 2 mm square. However, in a conventional light receiving module, a bonding pad region, or the like, is required for bonding between the current control section and the wiring pattern, and therefore the height of the side of the carrier, whereon the substrate is fixed, becomes approximately 4 mm, at the least. Moreover, the height of the case accommodating this carrier becomes approximately 10 mm, at the least.

In this way, in a conventional light receiving module, the dimensions of the module as a whole are large with respect to the dimensions of the optical element and current control section. Consequently, it has been difficult to achieve compactification of optical devices containing optical modules.

Therefore, a compactified optical module has been desired.

In an optical module, the optical element, such as a light receiving element, must be positioned accurately with respect to the end of the optical fiber, in order to raise optical coupling efficiency with the optical fiber. In a conventional optical module, an optical element, such as a light receiving element, is first fixed to a substrate and then installed in an optical module by fixing the substrate to a carrier. In these respective fixing stages, it has been impossible to avoid positional shifting from the prescribed fixed position. Therefore, in conventional optical modules, it has been difficult to achieve accurate positional registration between the end of an optical fiber and the optical element, due to this positional shifting.

Therefore, desirably, an optical module whereby accurate positional registration between an optical fiber and optical element can be readily achieved is desired.

Moreover, in a conventional optical module, the optical element, such as a light receiving element, and the current control section, such as an amp, are connected together by means of wires. Therefore, in a conventional optical module, the wiring between the optical element and current control section becomes long, the resonant frequency is towards the lower frequencies, thus making resonance liable to occur, and therefore making high-frequency signal transmission difficult to achieve.

Therefore, even more desirably, an optical module which enables high-frequency signal transmission is desired.

### SUMMARY OF THE INVENTION

The present invention is premised on an optical module comprising an optical element, a current control section, and a holding section whereon the optical element and current control section are provided. In this optical module, the holding section comprises a first surface, and a second surface located in a plane which intersects with the plane containing the first surface. The optical element is provided on the first surface, and the current control section is installed on the second surface. As well as perfect planes, the first and second surfaces may include planes which are gently curved. In this case, the plane containing the first surface indicates a plane extending practically along the first surface, and the plane where the second surface is located indicates a plane extending practically along the second surface.

According to this arrangement, the optical element and the current control section are located in different planes which are mutually intersecting. Therefore, the module as a whole can be compactified in comparison with cases where the optical element and the current control section are located in the same plane.

According to another aspect of the present invention, an arrangement may be adopted wherein the first surface and second surface are respectively located in planes which are virtually perpendicular to each other.

According to another aspect of the present invention, an arrangement may be adopted wherein the holding section comprises a flexible sheet-shaped carrier, to the surface of which the optical element and current control section are fixed, and a holding member which supports this sheet-shaped carrier.

According to this arrangement, since the optical element and current control section are readily mounted on the sheet-shaped carrier, work efficiency in the manufacture of the optical module is raised. Furthermore, since, after mounting the optical element and current control section, the sheet-shaped carrier can be bent and mounted along the contour of the holding member, work efficiency in the manufacture of the optical module is raised.

According to another aspect of the present invention, an arrangement may be adopted wherein, when the holding member has an approximately rectangular parallelepiped shape, the portion of the sheet-shaped carrier whereon the current control section is fixed is located on one surface of the holding member, and the portion of the sheet-shaped carrier whereon the optical element is fixed is located on a surface of the holding member adjacent to the aforementioned one surface.

According to another aspect of the present invention, an arrangement may be adopted wherein the one surface of the holding member is the top surface of the holding member.

According to this arrangement, the optical element is positioned on a side of the holding member. Therefore, it is possible to form the holding member to a height dependent on the length of the shorter sides of the optical element. Consequently, the height of the optical module can be reduced.

According to another aspect of the present invention, an arrangement may be adopted wherein the optical element is fixed to one surface of the sheet-shaped carrier, the current control section is fixed to another surface of the sheet-shaped carrier, a recess section is provided in the holding member, and the sheet-shaped carrier is held by the holding member such that the current control section is accommodated in the recess section.

According to this arrangement, since the current control section is accommodated in the recess section, the height of the optical module is reduced.

According to another aspect of the present invention, an arrangement may be adopted wherein an optical element sealing section for sealing the optical element is provided.

According to this arrangement, the possibility of the optical element being damaged during manufacture or use of the optical module is reduced.

According to another aspect of the present invention, an arrangement may be adopted wherein the optical element sealing section is formed by transfer moulding using a transparent material.

According to another aspect of the present invention, an arrangement may be adopted wherein a recess section for inserting the end of an optical fiber is provided in the optical element sealing section.

According to this arrangement, positional registration between the optical fiber and optical element is completed simply by inserting the end of the optical fiber into the recess section. Therefore, accurate positional registration between the optical element and the end of the optical fiber can be achieved readily. Consequently, work efficiency in the manufacture of the optical module is raised.

According to another aspect of the present invention, an arrangement may be adopted wherein the lower surface of the recess section is provided with a shape and dimensions corresponding to the end of an optical fiber.

According to this arrangement, positional registration between the optical fiber and optical element can be conducted more accurately.

According to another aspect of the present invention, an arrangement may be adopted wherein a current control section sealing section for sealing the current control section is provided.

According to this arrangement, the possibility of the current control section being damaged during manufacture or use of the optical module is reduced.

According to another aspect of the present invention, an arrangement may be adopted wherein the optical element is a light receiving element, and the current control section is an amplifier.

According to another aspect of the present invention, an arrangement may be adopted wherein the optical element is a light-emitting element, and the current control section is a driver IC.

Another aspect of the present invention is premised on an optical module comprising an optical element, a current control section, and a holding member for holding the optical element and current control section. In this optical module, the current control section is provided on the holding member, and the optical element is provided on the upperside or active area side surface of the current control section.

According to this arrangement, since the optical element and the current control section form a layered structure, the optical module is small in size.

According to another aspect of the present invention, an arrangement may be adopted wherein the optical element is bonded to the current control section by bumps.

According to this arrangement, connection between the optical element and the current control section is made by means of the bumps. Therefore, wiring inductance is reduced compared to conventional metal wiring, and transmission of higher frequency signals becomes possible.

According to another aspect of the present invention, an arrangement may be adopted wherein the holding section comprises a metal plate, and the current control section is provided on the metal plate.

According to another aspect of the present invention, an arrangement may be adopted wherein a first step section is formed by the holding member, and there is also provided a casing having an opening comprising a second step section of complementary shape to the first step section around the perimeter thereof.

According to this arrangement, positional registration of the optical fiber with respect to the casing is completed simply by mounting the holding section, to which the current control section is attached, onto the casing, by coupling the first step section and the second step section. Consequently, accurate positional registration between the optical element and the end of the optical fiber is achieved simply by positional registration of the end of the optical fiber with respect to the casing.

According to another aspect of the present invention, an arrangement may be adopted wherein a covering section for covering the optical element and the current control section is provided.

According to this arrangement, the possibility of the optical element and current control section being damaged is reduced.

According to another aspect of the present invention, an arrangement may be adopted wherein a first coupling section is formed by the covering section, and there is also provided a casing having an opening comprising a second coupling section of complementary shape to the first coupling section around the perimeter thereof.

According to this arrangement, positional registration of the optical fiber with respect to the casing is completed simply by installing the holding section, to which the current control section is attached, to the casing, by coupling the first coupling section and second coupling section. Therefore, accurate positional registration between the optical element and the end of the optical fiber is achieved simply by positional registration of the end of the optical fiber with respect to the casing.

According to another aspect of the present invention, an arrangement may be adopted wherein, when the optical element is an optical element provided with a light-receiving section or light-emitting section at the side end surface thereof, a groove is formed in the upperside or active area side surface of the current control section to accommodate the end portion of an optical fiber.

According to this arrangement, positional registration of the end of an optical fiber with respect to the optical element is completed simply by accommodating the end of the optical fiber in the groove.

According to another aspect of the present invention, an arrangement may be adopted wherein the groove has a V-shaped cross-section.

According to another aspect of the present invention, an arrangement may be adopted wherein the optical element is a light receiving element, and the current control section is an amplifier.

According to another aspect of the present invention, an arrangement may be adopted wherein the optical element is a light-emitting element, and the current control section is a driver IC.

According to another aspect of the present invention, an arrangement may be adopted wherein the holding section is a plate-shaped member, the first surface is one side of the plate-shaped member, the second surface is the upper surface of the plate-shaped member, and the current control section is incorporated in the upper surface of the plate-shaped member.

According to this arrangement, since the current control section is positioned inside the holding section, which is formed by a plate-shaped member, the overall module is further compactified.

According to another aspect of the present invention, an arrangement may be adopted wherein the one side, whereon the optical element is provided, is a surface obliquely angled with respect to the plane intersecting perpendicularly with the lower surface of the plate-shaped member.

Furthermore, according to another aspect of the present invention, an arrangement may be adopted wherein, when the plate-shaped member is a silicon wafer, the obliquely angled surface is formed along the crystal surface of the silicon wafer.

According to this arrangement, it is possible to achieve a uniform angle of the oblique surface in a plurality of optical modules, thereby reducing product variation.

According to another aspect of the present invention, an arrangement may be adopted wherein the holding member is a plate-shaped member, the first surface is one side of the plate-shaped member, the second surface is the upper surface of the plate-shaped member, and the current control section is provided directly onto the upper surface of the plate-shaped member.

Furthermore, according to another aspect of the present invention, an arrangement may be adopted wherein a recess section capable of accommodating the current control section is formed in the upper surface, and the current control section is positioned in the recess section.

According to this arrangement, since the current control section is positioned in the holding section, which is formed by a plate-shaped holding member, the overall module is further compactified.

According to another aspect of the present invention, an arrangement may be adopted wherein the one side, whereon the optical element is provided, is angled obliquely with respect to the plane intersecting perpendicularly with the lower surface of the plate-shaped member.

According to another aspect of the present invention, an arrangement may be adopted wherein the plate-shaped member is provided, internally, with a capacitor for preventing oscillation of the optical element.

According to this arrangement, it is possible to prevent oscillation of the optical element, without increasing the dimensions of the optical module.

### BRIEF DESCRIPTION OF THE DRAWINGS

Fig. 1 is a schematic perspective view showing the structure of a light receiving module according to a first embodiment;
Fig. 2 is a plan view of a tape carrier mounted to the light receiving module according to the first embodiment;
Fig. 3 is a view showing a light receiving module according to a second embodiment, and it shows a sectional view cut in the direction in which light enters the light receiving module;
Fig. 4 is a view showing a light receiving module according to a third embodiment, and it shows a sectional view cut in the direction in which light enters the light receiving module;
Fig. 5 is a schematic perspective view showing a state where a light receiving element array and an amp fixed to a tape carrier are sealed respectively by means of transparent material, in the third embodiment;
Fig. 6 is an enlarged approximate perspective view of a portion of a light receiving element array sealing section in a light receiving module according to a fourth embodiment;
Fig. 7 is a sectional view along line VII - VII in Fig. 6, and it shows a state where the end of an optical fiber is inserted into a recess section in the light receiving element array sealing section;
Fig. 8 is a schematic perspective view showing the appearance of a light receiving module according to a fifth embodiment;
Fig. 9 is a schematic side view showing the internal structure of a light receiving module according to the fifth embodiment;
Fig. 10 is a schematic perspective view showing the state of a light receiving module according to the fifth embodiment during manufacture;
Fig. 11 is a schematic view showing a state where a light receiving module according to the fifth embodiment is mounted in a casing;
Fig. 12 is a schematic perspective view showing the external appearance of a light receiving module according to a sixth embodiment;
Fig. 13 is a schematic view showing a state where a light receiving module according to the sixth embodiment is mounted in a casing;
Fig. 14 is a schematic view showing a further use example of a light receiving module according to the sixth embodiment;
Fig. 15 is a schematic sectional view showing the internal structure of a light receiving module according to a seventh embodiment;
Fig. 16 is a schematic drawing showing a state where a light receiving module according to the seventh embodiment is mounted in a casing;
Fig. 17 is a schematic perspective view showing the external appearance of a light receiving module according to an eighth embodiment;
Fig. 18 is a schematic view showing a state where a light receiving module according to the eighth embodiment is mounted in a casing;
Fig. 19 is a schematic side view showing the structure of a light receiving module according to a ninth embodiment;
Fig. 20 is a schematic perspective view showing the form of an amp used in the arrangement of the light receiving module according to the ninth embodiment;
Fig. 21 is a schematic perspective view showing the internal structure of a light receiving module according to a tenth embodiment;
Fig. 22 is a schematic side view of a light receiving module;
Fig. 23 is a schematic perspective view showing the arrangement of a light receiving module according to an eleventh embodiment;
Fig. 24 is a schematic perspective view showing the arrangement of a plate-shaped member, which is a holding section provided in a light receiving module according to a twelfth embodiment;
Fig. 25 is a schematic vertical cross-sectional view showing the arrangement of a light receiving module according to the twelfth embodiment;
Fig. 26 is a schematic vertical cross-sectional view showing the arrangement of a plate-shaped member, which is a holding section in a light receiving module according to a thirteenth embodiment;
Fig. 27 is an enlarged perspective view showing a portion of the plate-shaped member of a light receiving module according to the thirteenth embodiment;
Fig. 28 is a cross-sectional view of a conventional light receiving module cut in the direction of light emitted from an optical fiber; and
Fig. 29 is a perspective view giving a schematic illustration of a structure wherein a conventional light receiving module is fixed inside a casing.

### DESCRIPTION OF THE PREFERRED EMBODIMENTS

Now, embodiments of the present invention is described with reference to the drawings. The drawings simply provide schematic illustrations for the purpose of understanding the present invention, but the invention is not limited by these illustrated examples. Furthermore, in the drawings, the hatching (diagonal lines) indicating a cross-section, has been omitted in certain places, in order to make the views easier to understand.

### (First embodiment)

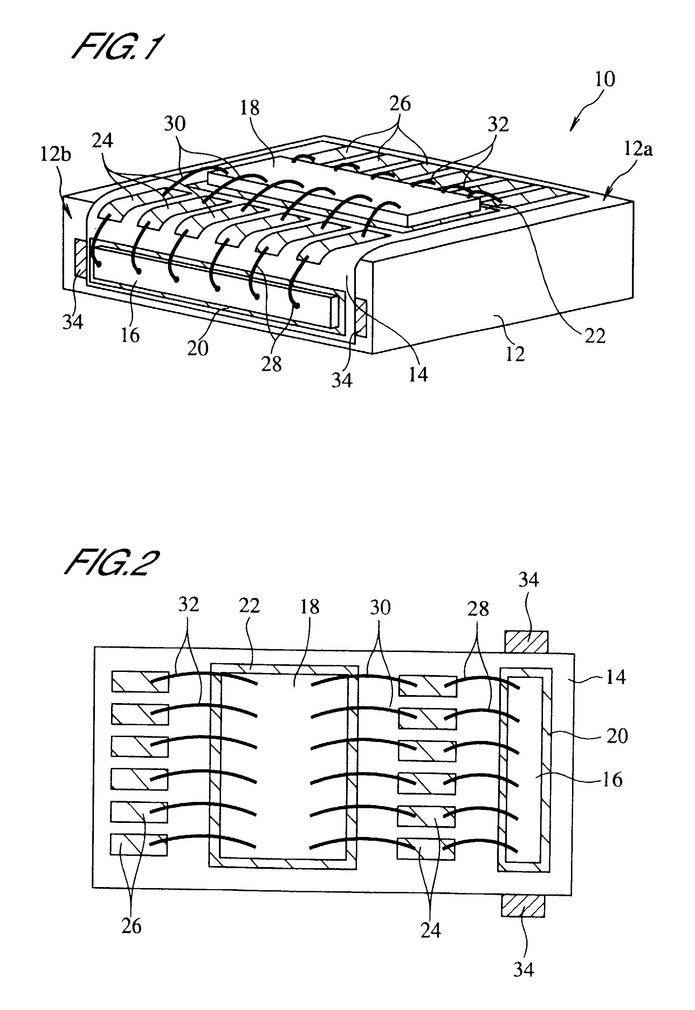

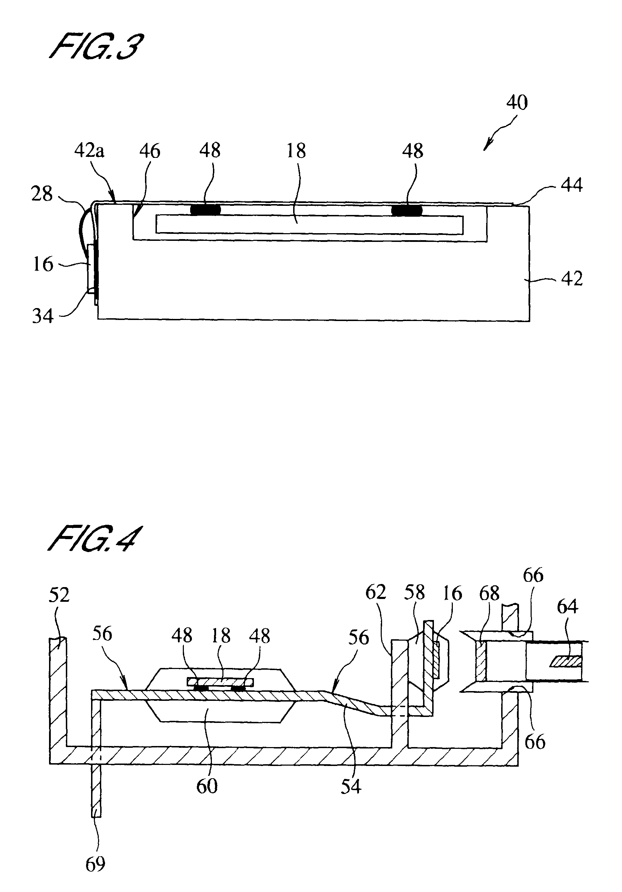

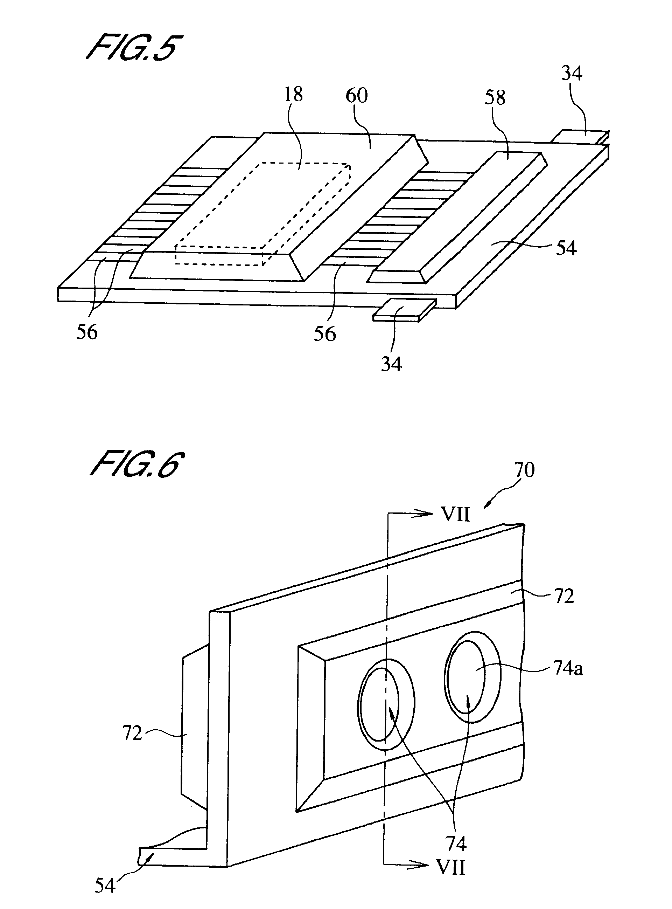

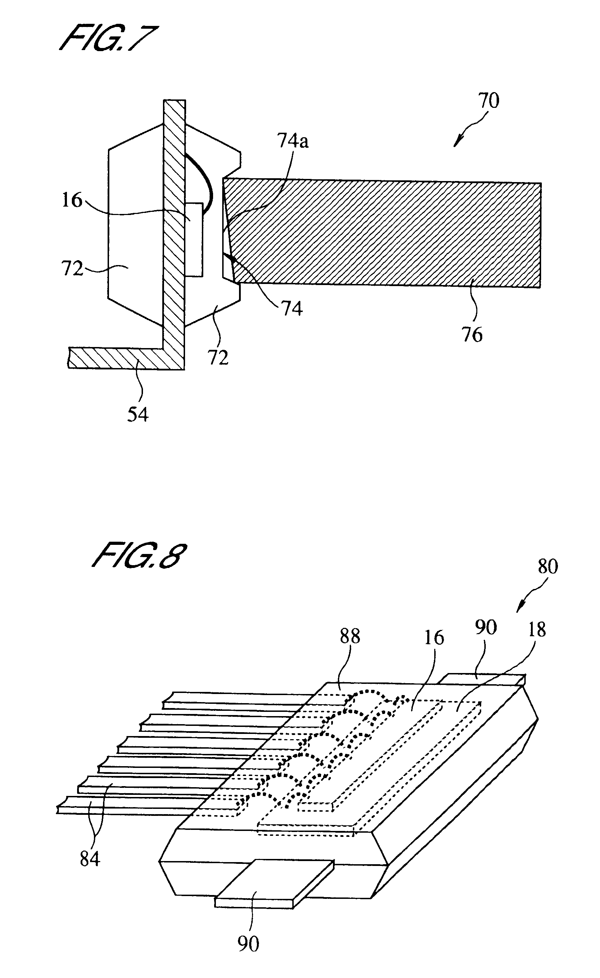

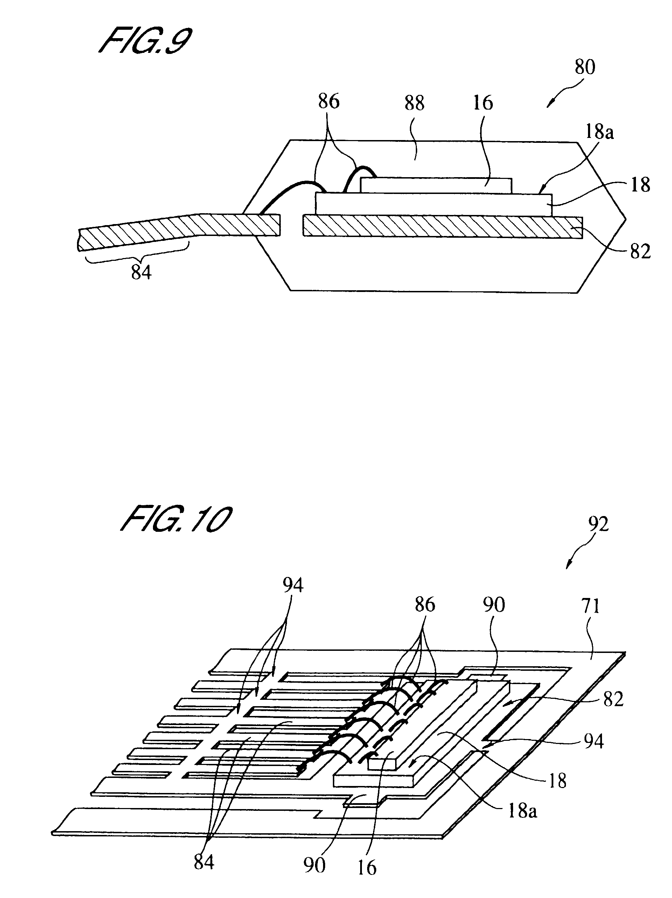

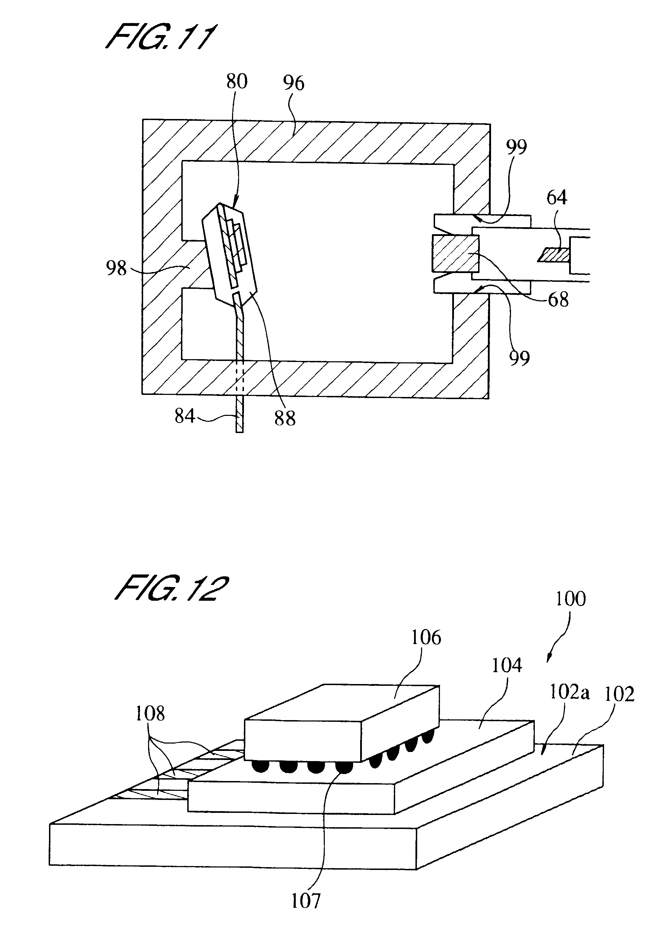

A light receiving module according to a first embodiment of the present invention is now described with reference to Fig. 1 and Fig. 2. Fig. 1 is a perspective view giving a schematic illustration of the structure of a light receiving module 10 according to the first embodiment. Fig. 2 is a plan view of a tape carrier.

As illustrated in Fig. 1, light receiving module 10 comprises a hold section which includes a holding member 12 and a tape carrier 14. The holding member 12 is made from a ferrous metal and has a generally rectangular parallelepiped shape. The tape carrier 14 is a carrier in the form of a elongated, flexible sheet, wherein a thin copper film is sandwiched between polyimide films. The tape carrier 14 is supported by the holding member 12 such that it covers the top surface 12a and one side 12b of the holding member 12.

As shown in Fig. 1 and Fig. 2, a light receiving element array 16 and an amp 18, which forms a current control section, are provided on one surface of the tape carrier 14. The light receiving element array 16 has essentially a thin rectangular parallelepiped shape (substantially rectangular shape), and it is positioned such that the longer edges thereof align with the shorter edge of the tape carrier 14 at an end portion of the tape carrier 14 in the longitudinal direction thereof.

The light receiving element array 16 as an optical element contains a plurality of light receiving elements (not shown) arranged in a row. A light receiving element is an element which generates electrical current in response to received light. The light receiving elements in the light receiving element array 16 are surface-type light receiving elements, and the light receiving element array 16 is provided in the light receiving module 10 such that the light-receiving surfaces of the light receiving elements face in the opposite direction to the tape carrier 14.

The amp 18 is positioned towards the other end of the tape carrier 14 from the centre thereof. The amp 18 is composed such that it amplifies, and converts the voltage of, the current generated by the light receiving elements. The height of the holding member 12 is set slightly longer than the length of the shorter sides of the light receiving element array 16.

The light receiving element array 16 is mounted on a light receiving element array pattern 20 formed on one side of the tape carrier 14. The light receiving element array pattern 20 is formed by removing a portion of the polyimide film on one side of the tape carrier 14 to expose the copper thin film, and then plating metal onto the exposed copper. The light receiving element array 16 is fixed to this light receiving element array pattern 20 using a chip-fixing material, such as solder, silver paste, or the like.

The amp 18 is mounted on an amp pattern 22 formed on one side of the tape carrier 14. Similarly to the light receiving element array pattern 20, the amp pattern 22 is formed by removing a portion of polyimide film on one side on the tape carrier 14 to expose the copper thin film, and then plating metal onto the exposed copper. The amp 18 is fixed to this amp pattern 22 using a chip-fixing material, such as solder, silver paste, or the like.

A plurality of rectangular first wiring patterns 24 are formed in parallel in the region between the light receiving element array pattern 20 and the amp pattern 22 on the tape carrier 14. The first wiring patterns 24 are formed in a similar manner to the light receiving element pattern 20. Furthermore, a plurality of rectangular second wiring patterns 26 are formed in parallel on the other end of the amp pattern 22 on the tape carrier 14. These second wiring patterns 24 are also formed in a similar manner to the light receiving element pattern 20.

The light receiving element array 16 and the first wiring patterns 24 are electrically connected by metal wires 28. The first wiring patterns 24 and the amp 18 are electrically connected by metal wires 30. Furthermore, the amp 18 and the second wiring patterns 26 are electrically connected by means of metal wires 32. Therefore, the light receiving module 10 is composed such that the current generated by the light receiving element array 16 is amplified and voltage-converted by the amp 18, and then transmitted externally via the second wiring patterns 26.

The tape carrier 14 comprises a pair of installation sections 34, 34. The installation sections 34 are rectangular sections formed by incorporating a copper film. The installation sections 34, 34 are formed respectively such that they project from a position outside the light receiving element array pattern 20 in the lateral direction thereof to a position outside the tape carrier 14 in the lateral direction thereof. Therefore, the installation sections 34 are provided in a position on a line extending in the longitudinal direction of the light receiving element array 16.

As illustrated in Fig. 1, the installation sections 34 are fixed to one side 12b of the holding member 12 by means of solder, or the like. Therefore, the portion of the tape carrier 14 whereon the light receiving element array 16 is attached is fixed to the side 12b of the holding member 12 by means of the installation section 34. The portion of the tape carrier 14 whereon the amp 18 is fixed is positioned such that it covers the top surface 12a of the holding member 12. In this way, the tape carrier 14 is bent and positioned such that it extends along the side 12b and the top surface 12a of the holding member 12. Accordingly, the light receiving element array 16 is positioned on the side 12b of the holding member 12 such that its shorter edges (namely, the shorter edges when observed in plan view), run in parallel to the vertical direction of the holding member 12, as illustrated in Fig. 1.

In this light receiving module 10, the portion of the tape carrier 14 whereon the light receiving element array 16 is mounted corresponds to a first surface, and the portion of the tape carrier 14 whereon the amp 18 is mounted corresponds to a second surface. The second surface is located in a plane which intersects with the plane containing the first surface. More specifically, in the light receiving module 10, the first surface and the second surface are located in a virtually perpendicular relationship. Therefore, in the light receiving module 10, the light receiving element array 16 and the amp 18 are mounted on surfaces which are virtually perpendicular to each other.

The light receiving module 10 having the foregoing structure is installed in a casing (not shown). One end of an optical fiber is connected to the casing in order to guide light to the light receiving elements. Wiring is also provided in the casing in order to extract an electrical signal, amplified and voltage-converted by the amp 18, via the second wiring patterns 26.

In the light receiving module 10 having the foregoing structure, only the portion of the tape carrier 14 whereon the light receiving element array 16 is attached, is fixed to the side 12b of the holding member 12, and the portion of the tape carrier 14, whereon the amp 18 forming a current control section is attached, is positioned on the top surface 12a of the holding member 12. Therefore, the holding member 12 can be formed to a height which is dependent only on the dimensions of the light receiving element array 16.

Moreover, in the light receiving module 10, the light receiving element array 16 is positioned on the side 12b of the holding member 12 such that its shorter edges run in parallel to the vertical direction of the holding member 12. Therefore, the height of the holding member 12 is dependent on the length of the shorter edges of the light receiving element array 16.

Consequently, the height of the holding member can be reduced compared to conventional light receiving modules, where both the light receiving element array and the amplifier are fixed to the same side of the holding member. Consequently, compactification of the light receiving module can be achieved.

In a light receiving module 10 having the foregoing structure, the light receiving element array and the amp can be fixed readily to the tape carrier 14. Therefore, the efficiency of the manufacturing process for the light receiving module is improved.

### (Second embodiment)

Next, a light receiving module 40 according to a second embodiment will be described with reference to Fig. 3. In essence, the light receiving module 40 has the same structure as the light receiving module 10 according to the first embodiment. Therefore, here, only points which differ form the light receiving module 10 according to the first embodiment will be described, and points which are the same as the light receiving module 10 according to the first embodiment are given similar reference numerals as the light receiving module 10 and detailed description thereof is omitted.

Fig. 3 shows the light receiving module 40 according to the second embodiment, and it gives a sectional view cut in the direction in which light enters the light receiving module.

As shown in Fig. 3, the light receiving module 40 is provided with a rectangular parallelepiped shaped holding member 42 and a tape carrier 44. A recess section 46 is formed in the top surface 42a of the holding member 42. This recess section 46 has dimensions such that it can accommodate an amp 18, which forms a current control section, and it is provided in a position where it can accommodate the amp 18, when the tape carrier 44 to which a light receiving element array 16 and amp 18 are fixed is mounted on the holding member 42.

In the light receiving module 40, the light receiving element array 16 is fixed to one side of the tape carrier 44 by means of a similar method to that in light receiving module 10. Furthermore, in the light receiving module 40, the amp 18 is fixed to another surface of the tape carrier 44 by means of bumps 48, 48. The light receiving element array 16 and the amp 18 are electrically connected such that the current generated by the light receiving element array 16 can be amplified and voltage-converted by the amp 18, and then transmitted externally from the light receiving module 40. Therefore, the tape carrier 44 has essentially the same structure as the tape carrier 14 in light receiving module 10, but since the light receiving element array 16 and the amp 18 are provided on opposite surfaces, it comprises different wiring patterns to the tape carrier 14.

In the light receiving module 40 having the foregoing structure, it is possible to reduce the height of the holding member. Therefore, it is possible to achieve compactification of the light receiving module.

Moreover, in the light receiving module 40, the light receiving element array 16 and the amp 18 can be fixed readily to the carrier 44. Therefore, the efficiency of the manufacturing process for the light receiving module is improved.

Moreover, in the light receiving module 40, the amp 18 fixed to the tape carrier 44 is accommodated in the recess section 46 in holding member 42. Therefore, the height of the light receiving module 40 can be reduced by an amount corresponding to the thickness of the amp 18, and hence even further compactification of the light receiving module can be achieved.

Moreover, since the amp 18 is fixed to the tape carrier 44 by means of bumps 48, it is possible to form a portion of the wiring from the amp 18 by means of these bumps 48. Therefore, it is possible to reduce wiring inductance compared to cases where metal wires are used, thereby enabling higher frequency signals to be transmitted.

### (Third embodiment)

Next, a light receiving module 50 according to a third embodiment will be described with reference to Fig. 4 and Fig. 5.

Fig. 4 shows a light receiving module 50 according to a third embodiment, and it gives a cross-sectional view cut in the direction in which light enters the light receiving module. Fig. 5 is a perspective view giving a schematic illustration of an aspect wherein a light receiving element array and an amp fixed to a tape carrier are sealed respectively by means of transparent material.

As shown in Fig. 4, the light receiving module 50 comprises a casing 52, which forms a holding member, and a tape carrier 54. In Fig. 4, the casing 52, a portion of which is omitted, is a box-shaped casing.

A light receiving element array 16 and an amp 18 are fixed to the tape carrier 54. The methods of fixing and connecting the light receiving element array 16 and the amp 18 are similar to those in the light receiving module 40 according to the second embodiment. In other words, the light receiving element array 16 is fixed by soldering to one surface of the tape carrier 54. The light receiving elements in the light receiving element array 16 are surface-type light receiving elements. In the light receiving module 50, the light receiving element array 16 is mounted to the tape carrier 54 such that the light-receiving surfaces of the light receiving elements face in an opposite direction to the tape carrier 54.

The amp 18 is fixed to the another surface of the tape carrier 54 by means of bumps 48. In the light receiving module 50, a wiring pattern 56 is formed for the light receiving element array 16 and the amp 18 such that the current generated by the light receiving element array 16 is amplified and voltage-converted by the amp 18 and then transmitted externally (Fig. 5).

The light receiving module 50 is provided with a light receiving element array sealing section 58 which seals the light receiving element array 16. After connection of the light receiving element array 16 has been completed, the light receiving element array sealing section 58 is formed by transfer moulding using a transparent epoxy resin, such that it seals the region of the tape carrier 54 whereon the light receiving element array 16 is fixed.

The light receiving module 50 also comprises an amp sealing section 60 for sealing the amp 18. After connection of the amp 18 has been completed, the amp sealing section 60 is formed by sealing the region of the tape carrier 54 whereon the amp 18 is fixed by means of transfer moulding using an epoxy resin.

In this way, the region where the light receiving element array 16 is fixed and the region where the amp 18 is fixed are respectively covered by transparent epoxy resin. The shape of these sealing sections 58, 60 takes the shape of the metal mould used in transfer moulding.

The tape carrier 54 is provided with installation sections 34 similar to those in the light receiving module 10 according to the first embodiment.

The casing 52 comprises a fixing member 62 for fixing the tape carrier 54. The fixing member 62 is a wall-shaped member which extends upwardly from the base of the casing 52.

The tape carrier 54 is fixed to the fixing member 62 by means of fixing sections 34 such that the portion thereof whereon the light receiving element array 16 is fixed extends upwards along the fixing member 62, and the portion thereof whereon the amp 18 is fixed extends in a virtually horizontal direction, which is perpendicular to the direction in which the fixing member 62 extends.

In the light receiving module 50, the portion of the tape carrier 54 whereon the light receiving element array 16 is mounted corresponds to a first surface, and the portion of the tape carrier 54 whereon the amp 18 is mounted corresponds to a second surface. The second surface is located in a plane which intersects with the plane containing the first surface. More specifically, in the light receiving module 50, the first surface and the second surface are positioned in a virtually perpendicular relationship. Therefore, in the light receiving module 50, the light receiving element array 16 and the amp 18 are provided in planes which are virtually perpendicular to each other.

An opening section 66 is formed in the casing 52 in order to introduce light from an optical fiber 64 into the casing 52. A lens 68 for focusing light from the optical fiber 64 is provided in this opening section 66.

In the light receiving module 50, the elements are positioned such that light focused by the lens 68 arrives at the light receiving element array 16 on the tape carrier 54 attached to the fixing member 62 in a highly efficient manner.

Furthermore, a lead 69 is fixed by solder, or the like, to the end of the wiring pattern 56, and is composed such that the output from the amp 18 is transmitted externally.

In the light receiving module 50 having the foregoing structure, it is possible to reduce the height of the casing which forms a holding member, and therefore compactification of the light receiving module can be achieved.

Furthermore, in the light receiving module 50, the light receiving element array and the amp can be fixed readily to the tape carrier 54. Therefore, the efficiency of the manufacturing process for the light receiving module can be improved.

Furthermore, since the amp 18 is mounted to the tape carrier 54 by means of bumps 48, a portion of the wiring from the amp 18 can be replaced with the bumps 48. Therefore, the wiring inductance can be reduced compared to when metal wires are used, and hence signals of higher frequency can be transmitted.

Moreover, in the light receiving module 50, since the light receiving element array 16 and the amp 18 are formed by moulding, the amp or light receiving element array will not contact surrounding elements, causing breakdown, during manufacture or use of the light receiving module 50. Furthermore, since they are sealed by epoxy resin, it is not necessary for the case itself to be sealed, and the durability of the light receiving module 50 is also improved.

### (Fourth embodiment)

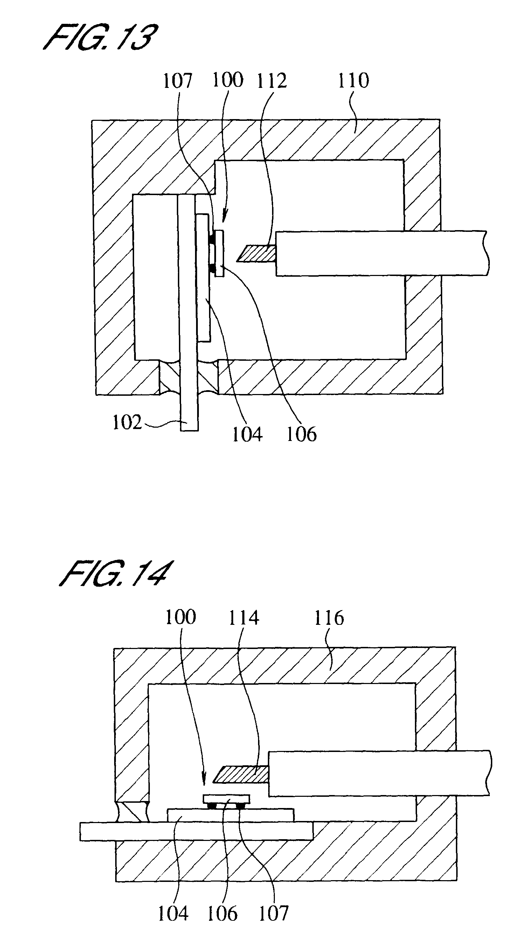

Next, a light receiving module 70 according to a fourth embodiment is described with reference to Fig. 6 and Fig. 7. Generally, the light receiving module 70 has the same structure as the light receiving module 50 in the third embodiment. Therefore, here, only points which differ from the light receiving module 50 in the third embodiment are described, and points which are similar to the light receiving module 50 in the third embodiment are denoted by the same reference numerals as light receiving module 50 and description thereof is omitted here.

Fig. 6 is an enlarged perspective view of a portion of the light receiving element array sealing material in the light receiving element array according to the fourth embodiment. Fig. 7 is a sectional view taken along line VII-VII in Fig. 6, and it shows a state where the end of an optical fiber is inserted into a recess section of the light receiving element array sealing material.

As shown in Fig. 6, in the light receiving module 70, recesses 74 are formed in the light receiving element array sealing section 72. The recesses 74 have a outwardly enlarging frustoconical-shape. The recesses 74 are formed in positions over the light-receiving sections of the light receiving element array 16. The bottom surfaces 74a of the recesses 74 have virtually the same dimensions and shape as the tip end of an optical fiber 76. In the light receiving module 70, the end portion of an optical fiber 76 is inserted directly into a recess 74, and light emitted from the optical fiber 76 is directed into the light receiving element array 16. Therefore, no lens is provided in the light receiving module for focusing the light from the optical fiber. Consequently, in the light receiving module 70, a hole, or the like, is formed for introducing an optical fiber into the casing.

When manufacturing a light receiving module 70, the light receiving element array and amp are fixed to a tape carrier 54 and sealing sections are formed by moulding. Thereupon, the tape carrier 54 is attached to a casing, and the ends of optical fibers are introduced into the casing and inserted into the recesses 74 in the light receiving module sealing section 72. By means of this insertion, the process of positioning the ends of the optical fibers 76 with respect to the light receiving element array 16 is completed.

In a light receiving module 70 having the foregoing structure, compactification can be achieved for similar reasons to the light receiving module 50 in the third embodiment, and furthermore, merits can be obtained in that it is possible to prevent the amp or light receiving element array from contacting surrounding elements during manufacture and use, and the case does not need to be sealed, etc.

Moreover, in the light receiving module 70, since positional registration between the optical fibers 76 and the light receiving element array 16 is completed simply by inserting the ends of the optical fibers 76 into recesses 74 in the light receiving element array sealing section 72, the manufacturing process is simplified.

### (Fifth embodiment)

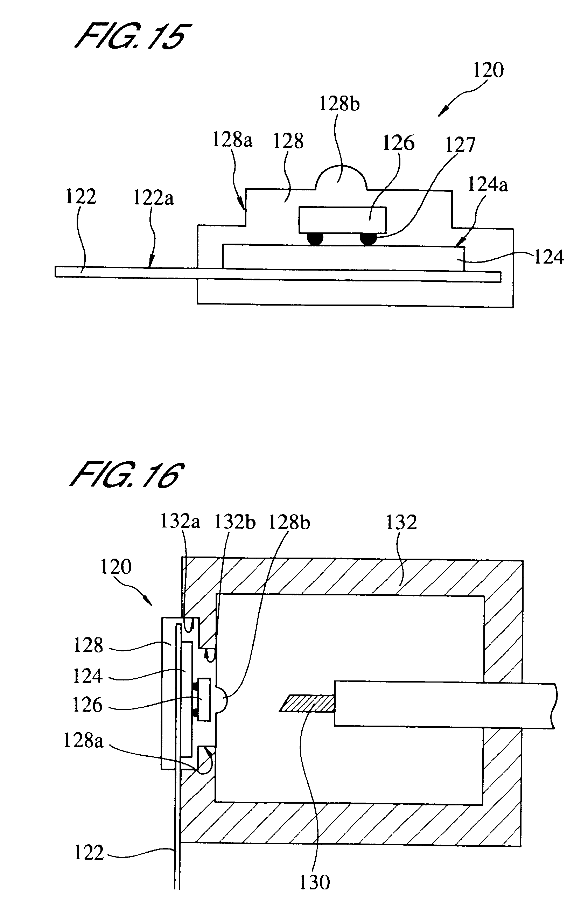

Next, a light receiving module 80 according to a fifth embodiment will be described with reference to Fig. 8 to Fig. 11.

Fig. 8 is a schematic perspective view showing the external appearance of a light receiving module 80 according to the fifth embodiment. Fig. 9 is a schematic view showing the internal structure of the light receiving module 80. Fig. 10 is a schematic perspective view showing the state of a light receiving module 80 during manufacture. Fig. 11 is a schematic view of a state where a light receiving module 80 is installed in a casing.

As shown in Fig. 8 and Fig. 9, the light receiving module 80 comprises an amp installation member 82, which is a copper plate, an amp 18, which forms a current control section, and a light receiving element array 16.

The amp 18 is fixed to the amp installation member 82 by means of dice bonding. Furthermore, the light receiving element array 16 is fixed to the upper surface (top surface) 18a of the amp 18 by means of dice bonding. The light receiving elements in the light receiving element array 16 are surface-type light receiving elements, and in the light receiving module 80, the light receiving element array 16 is mounted on the amp 18 such that the light-receiving surfaces of the light receiving elements face in the opposite direction to the amp 18.

The light receiving element array 16 is mounted on the upper side or active area side surface 18a of the amp 18 outside the active region thereof. Copper lead members 84 are positioned adjacent to the amp installation member 82. The light receiving element array 16 and the amp 18, and the amp 18 and the lead members 84 are each connected electrically by means of wire bonding using metal wires 86. Furthermore, the amp installation member 82, amp 18, light receiving element array 16 and the end portions of one end of the lead members 84 are sealed by a covering section 88 formed by moulding a transparent resin.

The amp installation member 82 is provided with a pair of installation sections 90, 90 on the two ends thereof. As illustrated in Fig. 8, the installation portion 90 externally projects from the covering section 88. The installation portion 90 is used for fixing the light receiving module 80 in a casing.

The amp installation member 82 and the lead members 84 are formed by severing cutting sections 94 from a copper sheet lead frame 92 formed in the shape illustrated in Fig. 10.

As shown in Fig. 10, the lead frame 92 comprises a region (amp fixing region) 82 forming the amp installation member 82, a region 84 forming the lead members 84, and regions 90 forming the installation sections 90. Moreover, cutting sections 94 which are severed in the subsequent processing are also provided in the lead frame 92.

When manufacturing a light receiving module 80, first, the amp 18 is fixed by dice bonding to the amp fixing region 82 of the lead frame 92, and the light receiving element array 16 is then fixed to the upper surface 18a of this amp 18 by dice bonding. Thereupon, the light receiving element array 16 and amp 18, and the amp 18 and lead members 84 are connected respectively by means of wire bonding using metal wires 86.

Next, the amp 18, and the like, for which wiring has been completed, is sealed by a covering section 88 formed by a transparent resin. Here, the other end portions of the lead members 84 and the installation sections 90 project externally from the covering section 88. Finally, the cutting sections 94 of the lead frame 92 are severed and a light receiving module 80 is obtained.

The light receiving module 80 is fixed inside a casing 96, as illustrated in Fig. 11. For example, here, the light receiving module 80 is fixed inside the casing 96 by, for example, fixing the installation section 90 to a projecting section 98 provided in advance in the casing 96.

As shown in Fig. 11, the other end portions of the lead members 84 project outside the casing 96, and form output terminals whereby a current amplified by the amp 18 can be transmitted. An opening section 99 is formed in the casing 96 for introducing light from an optical fiber 64 into the casing 96. A lens 68 for focusing the light from the optical fiber 64 is located in the opening section 99.

In the casing 96, the elements are positioned such that light focused by the lens 68 arrives at the light receiving element array 16 in the light receiving module 80 installed on the projecting section 98 in a highly efficient manner.

In this light receiving module 80, since the light receiving element array 16 is provided on the upper surface 18a of the amp 18, it is possible to reduce the length of the wiring between the light receiving element array 16 and the amp 18. Therefore, the resonant frequency can be shifted to a higher frequency, thereby enabling high-frequency signal transmission.

Furthermore, the light receiving element array 16 and the amp 18 are fixed by means of a thin metal plate, and form a structure wherein the light receiving element array is mounted on the amp, and therefore the dimensions thereof can be reduced. Consequently, a smaller size of casing can also be used.

The material of the lead frame 92 is not limited to copper plate, for example, an iron or 42 alloy plate may be used.

Furthermore, the light receiving module 80 has a so-called chip-on-chip structure, wherein the light receiving element array 16 is layered onto the amp 18, but it is also possible to adopt a structure wherein the amp 18 and light receiving element array 16 are placed alongside each other and sealed by a resin covering section.

Moreover, in the light receiving module 80, the upper surface of the covering section is flat. However, it is also possible to form a recess section in a position on the upper surface of the covering section directly above the light-receiving sections of the light receiving elements in the light receiving element array, similarly to the light receiving module 70 in the fourth embodiment. In this case, no lenses are required. If a recess section of this kind is formed, it is extremely easy to register the position of the end of an optical fiber with respect to the light-receiving sections.

### (Sixth embodiment)

Next, a light receiving module 100 according to a sixth embodiment will be described with reference to Figs. 12 - 14.

Fig. 12 is a schematic perspective view showing the external appearance of a light receiving module 100 according to a sixth embodiment. Fig. 13 is a schematic cross-sectional view of a state where the light receiving module 100 is installed in a casing.

As illustrated in Fig. 12, the light receiving module 100 comprises a substrate 102, an amp 104, which forms a current control section, mounted on the substrate 102, and a light receiving element 106, which is an optical element mounted on the amp 104. A wiring pattern 108 is formed on the upper surface 102a of the substrate 102. The amp 104 is fixed to the substrate 102 by bonding involving bumps, such that it connects with the wiring pattern 108. A bonding pattern is formed on the upper surface of the amp 104 and the light receiving element 106 is bonded to this bonding pattern by means of bumps 107. The light receiving element 106 is a surface-type light receiving element, and in the light receiving module 100, it is mounted to the amp 104 such that its light-receiving surface faces in the opposite direction to the amp 104. Furthermore, the sides of the light receiving element 106 and the upper surface of the amp 104 are coated with resin.

As shown in Fig. 13, the light receiving module 100 having the foregoing structure is installed in a casing 110. One end of the substrate 102 is positioned outside the casing 110, and the wiring pattern 108 fabricated in this region forms an external terminal of the light receiving module 100. The end of an optical fiber 112 is positioned inside the casing 110. The optical fiber 112 is positioned such that light emitted from the optical fiber 112 arrives at the light-receiving surface of the light receiving element 106 in a highly efficient manner.

In the light receiving module 100 having the foregoing structure, a so-called chip-on-chip structure is adopted, wherein the light receiving element 106 is mounted on the amp 104. Therefore, the vertical dimensions are reduced, and compactification becomes possible. Moreover, the light receiving element 106 is connected to the amp 104 via bumps 107, the transmission path is shortened and high-frequency transmission becomes possible. Furthermore, since a wiring pattern 108 formed on the substrate 102 is used as an external terminal, the casing can be simplified, and installation onto the casing is also simplified.

In the light receiving module 100, the substrate 102 is used as a holding section for holding the amp 104. However, a lead frame, tape carrier, or the like, as described in the foregoing embodiment may be used as the holding section. Furthermore, silver paste bonding may be used for the process of bonding the amp to the substrate.

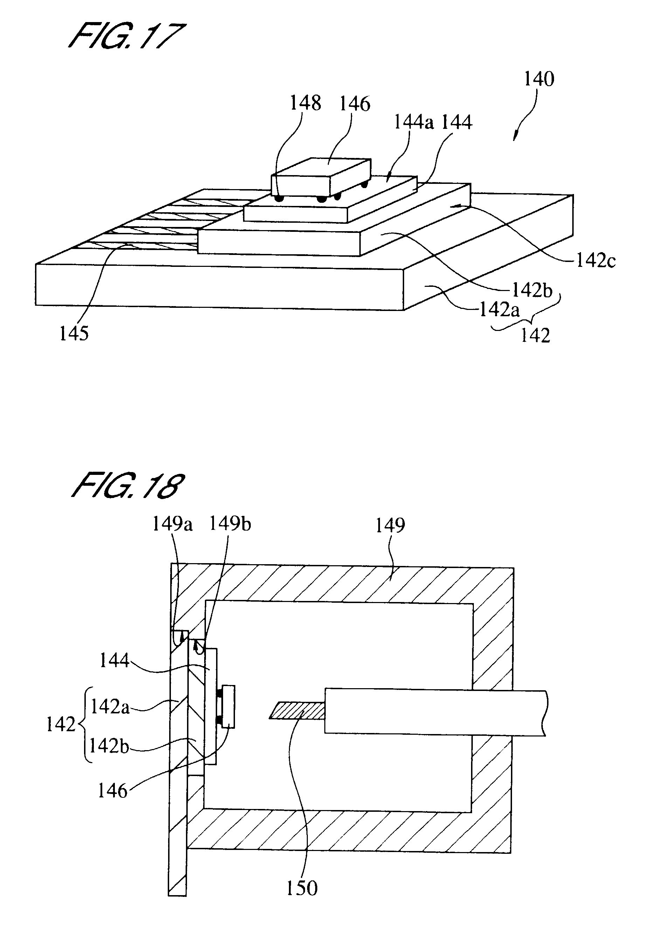

The light receiving module 100 can be combined with an optical fiber 114, wherein the end of the optical fiber is severed at an angle of 45° to the axis of the optical fiber and the direction of the light emitted from the optical fiber is perpendicular to the axis of the optical fiber. In this case, as illustrated in Fig. 14, the light receiving module 100 is positioned inside the casing 116 such that the end of the optical fiber 114 and the light receiving element 106 lie mutually in parallel.

### (Seventh embodiment)

Next, a light receiving module 120 according to a seventh embodiment will be described with reference to Fig. 15 and Fig. 16.

Fig. 15 is a schematic sectional view showing the internal structure of a light receiving module 120 according to a seventh embodiment. Fig. 16 is a schematic cross-sectional view showing a state where the light receiving module 120 is installed in a casing.

As shown in Fig. 15, the light receiving module 120 comprises a frame 122, which is a plate-shaped body made of copper, an amp 124, forming a current control section, which is mounted to the frame 122, and a light receiving element 126, which is an optical element mounted on the amp 124. A wiring pattern is formed on the upper surface 122a of the frame 122. The amp 124 is fixed to the frame 122 by dice bonding such that it contacts the wiring pattern. A bonding pattern is formed on the upper surface 124a of the amp 124, and the light receiving element 126 is bonded to this bonding pattern by means of bumps 127. The light receiving element 126 is a surface-type light receiving element, and in the light receiving module 120, it is mounted to the amp 124 such that the light-receiving surface thereof faces in the opposite direction to the amp 124.

The light receiving module 120 comprises the amp 124, the light receiving element 126 and a covering section 128 which covers the portion of the frame 122 whereon the amp 124 is fixed. The covering section 128 is formed by transfer moulding using transparent epoxy resin. As shown in Fig. 15, the covering section 128 has a form comprising laminated rectangles of different sizes, and a stepped portion 128a is formed at the perimeter thereof. This stepped portion 128a functions as a first coupling section when installing the light receiving module 120 onto the casing. The portion of the covering section 128 which covers the light-receiving section of the light receiving element 124 is taken as a lens section 128b formed in a convex shape. This lens section 128b is composed such that light emitted from an optical fiber 130 is directed to the light-receiving section of the light receiving element 126.

The light receiving module 120 having the foregoing structure is installed in a casing 132 as illustrated in Fig. 16. An opening 132a is formed in the casing 132 in order to install the light receiving module 120. In the edge region of the opening 132a, there is formed a stepped portion (second coupling section) 132b having complementary dimensions and shape to the stepped portion 128a of the covering section 128 in the light receiving module 120. Therefore, the light receiving module 120 is installed in the casing 132 by coupling the stepped portion (first coupling section) 128a of the covering section 128 with the stepped portion (second coupling section) 132b of the casing 132. One end of the frame 122 is located outside the casing 132, and the wiring pattern fabricated on this region forms an external terminal of the light receiving module 120. The end of an optical fiber 130 is positioned inside the casing 132. This optical fiber 130 is positioned such that light emitted from the optical fiber 130 arrives at the light-receiving surface of the light receiving element 126 in a highly efficient manner.

In the light receiving module 120 having the foregoing structure, a stepped portion 128a is formed in the covering section 128. Therefore, when the stepped portion 128a is installed in a casing having a stepped portion of complementary shape, the light receiving module 120 and the casing are positioned with respect to each other simply by coupling the two stepped portions.

Furthermore, a lens 128b is formed in the covering section 128. Therefore, the light from the optical fiber 130 can be directed to the light receiving element 126 with good efficiency, without providing a separate lens.

The light receiving module 120 adopts a so-called chip-on-chip structure, wherein the light receiving element 126 is mounted on the amp 124. Therefore, the vertical dimensions thereof are reduced and compactification becomes possible. Furthermore, since the light receiving element 126 is connected to the amp 124 by means of bumps 127, the transmission path is shortened and high-frequency transmission becomes possible. Moreover, since the wiring pattern formed on the frame 122 can be used as an external terminal, the casing can be simplified and installation onto the casing can also be simplified.

A different metal material, such as 42 alloy, for example, can also be used for the frame 122.

### (Eighth embodiment)

Next, a light receiving module 140 according to an eighth embodiment will be described with reference to Fig. 17 and Fig. 18.

Fig. 17 is a schematic perspective view showing the external appearance of a light receiving module 140 according to an eighth embodiment. Fig. 18 is a schematic view showing a state where the light receiving module 140 is installed in a casing.

As shown in Fig. 17, the light receiving module 140 comprises a substrate 142, which is a plate-shaped body made of copper, an amp 144, forming a current control section, which is mounted on the substrate 142, and a light receiving element 146, which is an optical element mounted on the amp 144. The amp 144 is fixed to the substrate 142 by dice bonding such that it connects with the wiring pattern. A bonding pattern is formed on the upper surface 144a of the amp 144 and the light receiving element 146 is bonded to this bonding pattern by means of bumps 148. The light receiving element 146 is a surface-type light receiving element, and in the light receiving module 140, it is mounted on the amp 144 such that its light-receiving surface faces in the opposite direction to the amp 144.

As shown in Fig. 17, the substrate 142 is composed by laminating two substrates 142a, 142b (e.g., ceramic substrates) of different sizes. Therefore, a first step section 142c is formed surrounding the upper, smaller substrate 142b. This first step section 142c serves as a coupling section when installing the light receiving module 140 in a casing. A wiring pattern 145 is formed on the upper surface of the lower, larger substrate 142a. The sides of the light receiving element 146 and the upper surface 144a of the amp 144 are coated with a resin.

The light receiving module 140 having the foregoing structure is installed in a casing 149 as shown in Fig. 18. An opening 149a is formed in the casing 149 in order to install the light receiving module 140. In the edge region of the opening 149a, there is formed a second step section 149b of complementary dimensions and shape to the first step section 142c in the substrate 142 of the light receiving module 140. Therefore, the light receiving module 140 is installed in the casing 149 by coupling the first step section 142c of the substrate 142 with the second step section 149b of the casing 149. One end of the substrate 142 is located outside the casing 149, and the wiring pattern fabricated in this region forms the external terminal of the light receiving module 140. The end of an optical fiber 150 is positioned inside the casing 149. The optical fiber 150 is positioned such that light emitted from the optical fiber 150 arrives at the light-receiving surface of the light receiving element 146 in a highly efficient manner.

In the light receiving module 140 having the foregoing arrangement, a first step section 142a is formed in the substrate 142. Therefore, when installing it in a casing having a stepped portion of complementary shape to the first step section 142c, the light receiving module 140 and the casing 148 are positioned with respect to each other simply by coupling the two step sections.

The light receiving module 140 has a so-called chip-on-chip structure, wherein the light receiving element 146 is mounted on the amp 144. Therefore, the vertical dimensions thereof are reduced and compactification becomes possible. Furthermore, since the light receiving element 146 is connected to the amp 144 by means of bumps, the transmission path is shortened and high-frequency transmission becomes possible. Moreover, since the wiring pattern formed on the substrate 142 is used as an external terminal, the casing can be simplified, and installation onto the casing can also be simplified.

### (Ninth embodiment)

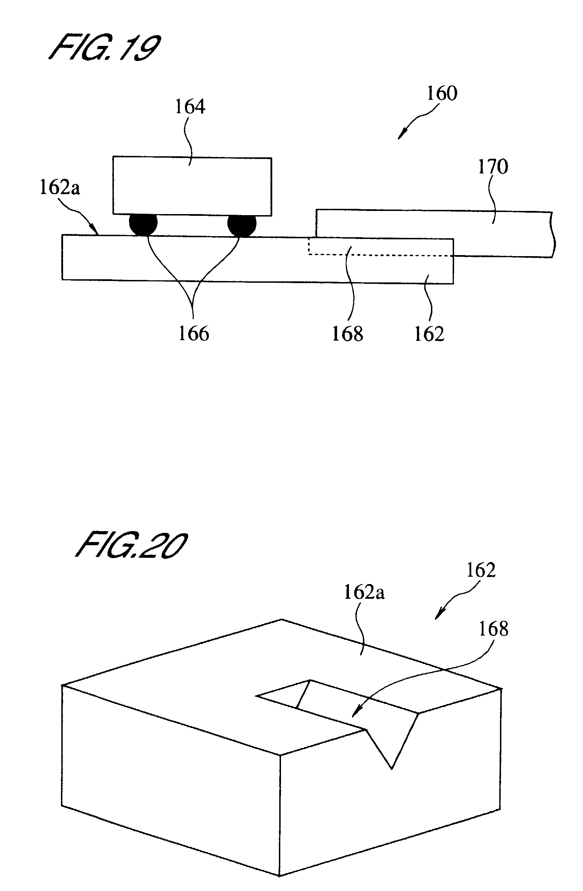

Next, a light receiving module 160 according to a ninth embodiment is described with reference to Fig. 19 and Fig. 20.

Fig. 19 is a schematic side view illustrating the structure of a light receiving module 160 according to a ninth embodiment. Fig. 20 is a schematic perspective view showing the shape of an amp used in the arrangement of this light receiving module 160.

As shown in Fig. 19, the light receiving module 160 comprises an amp 162, which forms a current control section, and a light receiving element 164, which is an optical element, mounted on the amp 162.

A bonding pattern is formed on the upper surface 162a of the amp 162, and the light receiving element 164 is bonded to this bonding pattern by means of bumps 166. The light receiving element 164 is an end face-type light receiving element.

Furthermore, as shown in Fig. 20, a groove 168 having a V-shaped cross-section is formed on the upper surface 162a of the amp 162. The amp 162 has a structure wherein it is formed into an IC and incorporated into a semiconductor substrate of Si, or the like. The groove 168 is formed in a region which is not used for the substrate circuit.

As illustrated in Fig. 19, the groove 168 can accommodate, in its longitudinal direction, the end portion of an optical fiber 170 which is combined with the light receiving module 160, and it is formed such that the centre of the core of the optical fiber 170 accommodated therein is aligned with the light-receiving section of the light receiving element 164 mounted on the amp 162.

The groove 168 is formed by anisotropic etching, before fabricating the amp circuit onto the substrate.

As shown in Fig. 19, the light receiving module 160 having the foregoing arrangement is combined with an optical fiber 170 by accommodating the end portion of the optical fiber 170 in the groove 168 and fixing this end portion therein.

In the light receiving module 160 having the foregoing structure, positional registration between the optical fiber 170 and the light receiving element 164 is completed simply by accommodating the end portion of the optical fiber 170 in the groove 168 in the amp 162.

Furthermore, the light receiving module 160 has a so-called chip-on-chip structure, wherein the light receiving element 164 is mounted on the amp 162. Therefore, the vertical dimensions thereof are reduced, and compactification becomes possible. Furthermore, since the light receiving element 164 is connected to the amp 162 by means of bumps 166, the transmission path is shortened and high-frequency transmission becomes possible.

### (Tenth embodiment)

Next, a light receiving module 180 according to a tenth embodiment of the present invention is described with reference to Fig. 21 and Fig. 22.

Fig. 21 is a schematic perspective view showing the structure of a light receiving module 180 according to the tenth embodiment. Fig. 22 is a schematic side view of the light receiving module 180.

As shown in Fig. 21, the light receiving module 180 comprises a plate-shaped member 182, which constitutes a holding section. The plate-shaped member 182 is formed by a silicon wafer, and it has a rectangular plate-shaped form.

One side 182a of the plate-shaped member 182 is obliquely formed with respect to the plane which intersects perpendicularly with the upper surface 182b and the lower surface 182c of the plate-shaped member 182. This oblique side 182a is formed along a silicon crystal surface of the plate-shaped member, which consists of a silicon wafer, and the angle θ between this surface and the lower surface 182c is 45°. This is because in the silicon wafer, the crystal surface of the silicon forms an angle of 45° with respect to the upper surface and lower surface of the wafer. The oblique surface is formed using an etching liquid or dicing saw, etc. capable of selective etching along the crystal surface.

A light receiving element array 184 is mounted on the oblique side 182a by means of dice bonding. The light receiving element array 184 contains a plurality of light receiving elements (not shown) aligned in a row. The light receiving elements are elements which generate an electric current in response to received light. The light receiving elements in the light receiving element array 184 are surface-type light receiving elements, and in the light receiving module 180, the light receiving element array 184 is mounted on the plate-shaped member 182 such that the light-receiving surfaces of the light receiving elements face in the opposite direction to the side 182a of the plate-shaped member 182.

In this embodiment, the light receiving element array 184 has generally the same dimensions and shape as the side 182a.

As illustrated in Fig. 21 and Fig. 22, an amp 186, forming a current control section, is built into the upper surface 182b of the plate-shaped member 182. In other words, the amp 186 is located in the upper portion of the plate-shaped member 182. The amp 186 is composed such that it amplifies, and converts the voltage of, the current generated by the light receiving elements.

On the upper surface 182b of the plate-shaped member 182, there are provided a plurality of first wiring pads 188 for making electrical connection to the light receiving element array 184, and a plurality of second wiring pads 190 for extracting the photoelectric current amplified by the amp 186. The first and second wiring pads 188, 190 are provided corresponding to each of the light receiving elements in the light receiving element array 184. The amp 186 and the wiring pads 188, 190 are electrically connected inside the plate-shaped member 182.

When manufacturing the light receiving module 180, after vapour deposition of gold (Au) onto the oblique side 182a, the light receiving element array 184 is dice bonded onto this gold-deposited surface using solder, or the like. The gold-deposited surface is used as an electrode for the light receiving elements. Thereupon, each of the light receiving elements and their corresponding first wiring pads 188 are electrically connected by wire bonding using metal wires 192, for example.

In the light receiving module having the foregoing structure, the amp 186 is positioned within the plate-shaped member, and therefore the height of the plate-shaped member 182 is dependent solely on the length of the shorter edges of the light receiving element array 184. Therefore, it is possible to achieve compactification of the light receiving module.

### (Eleventh embodiment)

Next, a light receiving module 200 according to an eleventh embodiment is described with reference to Fig. 23.

Fig. 23 is a schematic perspective view showing the structure of a light receiving module 200 according to an eleventh embodiment.

As shown in Fig. 23, the light receiving module 200 comprises a plate-shaped member 202, which constitutes a holding section. The plate-shaped member 202 is made from ceramic, and has a rectangular plate-shaped form. One side 202a of the plate-shaped member 202 is angled obliquely with respect to the plane intersecting perpendicularly with the upper surface 202b and lower surface 202c of the plate-shaped member 202.

A light receiving element array 204 is mounted on the obliquely angled side 202a by means of dice bonding. The light receiving element array 204 contains a plurality of light receiving elements (not shown) aligned in a row. The light receiving elements are elements which generate electric current in response to received light. The light receiving elements in the light receiving element array 204 are surface-type light receiving elements, and in the light receiving module 200, the light receiving element array 204 is mounted on the plate-shaped member 202 such that the light-receiving surfaces of the light receiving elements surface in the opposite direction to the side 202a of the plate-shaped member 202.

As illustrated in Fig. 23, an amp 206 forming a current control section, is provided on the upper surface 202b of the plate-shaped member 202. In this embodiment, the amp 206 is a chip-shaped structure forming an integrated circuit approximately 350 µm thick, and it is composed such that it amplifies, and converts the voltage of, the current generated by the light receiving elements.

A pattern is formed by metal plating onto the surface of the plate-shaped member 202. This pattern comprises an amp pattern 208 formed on the upper surface 202b of the plate-shaped member 202, a first wiring pattern 210 for connecting the amp 206 and the light receiving element array 204, a second wiring pattern 212 for extracting an output current from the amp 206, and a light receiving element array pattern 214.

When manufacturing the light receiving module 200, a chip fixing agent, such as solder or silver paste, is coated onto the light receiving element array pattern 214, and the light receiving element array 204 is dice bonded thereonto. Furthermore, a chip fixing agent, such as solder or silver paste, is coated onto the amp pattern 208, and the amp 206 is dice bonded thereonto. Thereupon, each of the light receiving elements and the corresponding first wiring pads 210 are electrically connected by wire bonding using metal wires 216, for example. Furthermore, the amp 206 is electrically connected to the first wiring pattern 210 and the second wiring pattern 212 by wire bonding using metal wires 218, for example.

### (Twelfth embodiment)

Next, a light receiving module 220 according to twelfth embodiment will be described with reference to Fig. 24 and Fig. 25. This light receiving module 220 has essentially the same structure as the light receiving module 200 according to the eleventh embodiment. Therefore, here, only points which differ from the light receiving module 200 according to the eleventh embodiment are described, and points which are the same as the light receiving module 200 according to the eleventh embodiment are given the same reference numerals as the light receiving module 200 and detailed description thereof is omitted here.

Fig. 24 is a schematic perspective view showing the arrangement of a plate-shaped member 222, which is a holding section provided in the light receiving module 220 according to the twelfth embodiment. Fig. 25 is a schematic vertical cross-sectional view showing the structure of the light receiving module 220 according to the twelfth embodiment.

As illustrated in Fig. 24, a recess section 224 of a shape and dimensions for accommodating an amp 206, which forms a current control section, is fabricated in the upper surface 222b of the plate-shaped member 222. A light-emitting element 204 is provided on the oblique side 222a of the plate-shaped member 222 through the pattern 214 coated thereon. An amp pattern 226 is formed by metal plating on the base 224a of this recess section 224.

In the light receiving module 220, an amp 206 is mounted on the amp pattern 226 in the recess section 224. Therefore, the amp 206 is mounted on the upper surface of the plate-shaped member 222 in a state whereby it is accommodated completely inside the recess section 224.

After accommodating the amp 206 in the recess section 224, in order to raise environmental resistance, and especially, humidity resistance, the recess section 224 is sealed by silicon resin, or the like.

Since the amp 206 is positioned inside the plate-shaped member 222, the light receiving module 220 having the foregoing structure can be compactified.

### (Thirteenth embodiment)

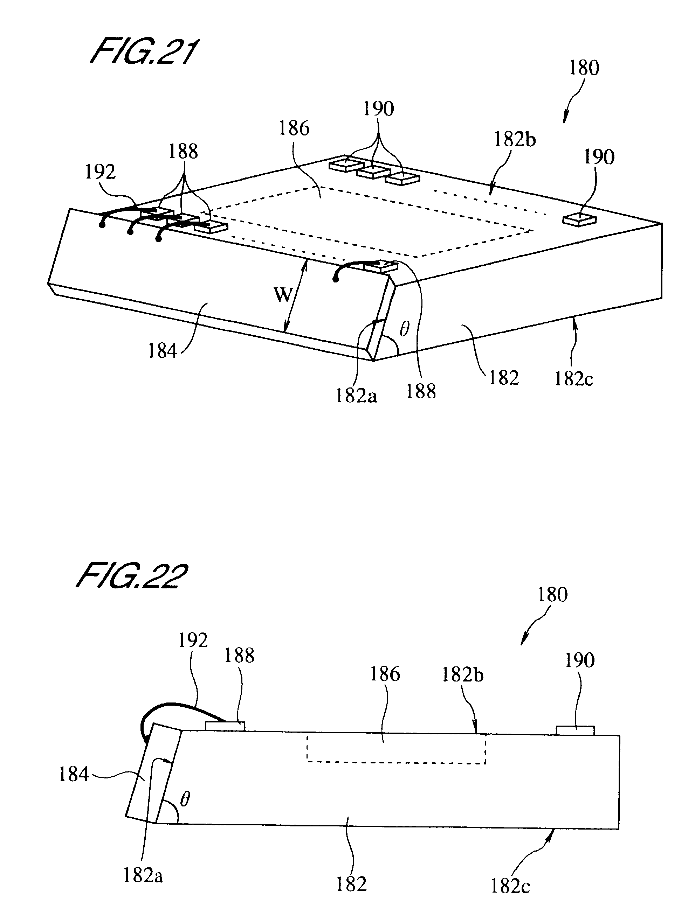

Next, a light receiving module 230 according to a thirteenth embodiment is described with reference to Fig. 26 and Fig. 27.

Fig. 26 is a schematic vertical cross-sectional view showing the structure of a plate-shaped member 232, which is a holding section of the light receiving module according to the thirteenth embodiment. Fig. 27 is an enlarged perspective view showing a portion of the plate-shaped member 232 of the light receiving module 230.

As shown in Fig. 26, in the light receiving module according to the thirteenth embodiment, the approximately rectangular plate-shaped member 232 has a laminated structure comprising a lower ceramic layer 234, a film capacitor 236, and an upper ceramic layer 238.

Furthermore, as illustrated in Fig. 26 and Fig. 27, one side of the plate-shape member 232 is set as an oblique surface 232a, similarly to the tenth embodiment. A light receiving element array pattern 240 on which a light receiving element array is mounted, is formed, by metal plating, for example, on this oblique surface 232a.

Moreover, a power supply pattern 242, an amp pattern 244 and a ground pattern 246 are formed by metal plating, for example, onto the upper surface 232b of the plate-shaped member 232.

A first through-contact 248 connecting the power supply pattern 242 with one surface of a film capacitor 236, and a second through-contact 250 for connecting the ground pattern 246 with the other surface of the film capacitor 236, are provided such that the capacitance between the power supply and the ground is protected.

A light receiving element array and amp are mounted on the plate-shaped member 232 having the foregoing structure, and wiring is implemented, similarly to the light receiving module according to the tenth embodiment, for example.

In the light receiving module according to the thirteenth embodiment comprising the plate-shaped member 232 having the foregoing structure, capacitance can be protected by means of a film capacitor provided in the plate-shaped member, which forms a holding section. Therefore, capacitance can be ensured without restricting the number of elements mounted on the surface of the holding section or increasing the dimensions of the light receiving module.

The present invention is not limited to the aforementioned embodiments, and a variety of alterations and modifications are possible, provided that these lie within the scope of the claims. For example, the aforementioned embodiments relate to a light receiving module, wherein a light receiving element is used as the optical element, and an amp is used as the current control section. However, the present invention can also be applied to an optical module (light-emitting module) which uses a light-emitting element, such as a semiconductor laser element, or the like, as an optical element, and a driver IC as a current control section.

As described above, according to the present invention, a compactified optical module is provided.

## Claims

1. An optical module(10; 40; 50; 70; 180; 200; 220; 230) comprising:
an optical element(16; 184; 204);
a current control section(18; 186; 206); and
a holding section (12, 14; 42, 44; 52, 54) whereon said optical element and said current control section are provided,
wherein said holding section comprises a first surface and a second surface located in a plane intersecting with the plane containing said first surface; and
said optical element is provided on said first surface and said current control section is provided on said second surface.

2. The optical module according to claim 1, wherein said first surface and said second surface are respectively located in planes which are substantially perpendicular to each other.

3. The optical module according to claim 1, wherein said holding section comprises a flexible sheet-shaped carrier (14; 44; 54), to the surface of which said optical element and said current control section are fixed, and a holding member (12; 42; 52) for holding said sheet-shaped carrier.

4. The optical module according to claim 3, wherein said holding member (12; 42; 52) has a schematicly rectangular shape, the portion of said sheet-shaped carrier (14; 44; 54) whereon said current control section is fixed is positioned on one surface of said holding member, and the portion of said sheet-shaped carrier whereon said optical element is fixed is positioned on a surface of said holding member adjacent to said one surface.

5. The optical module according to claim 4, wherein one surface of said holding member is the top surface (12a) of said holding member.

6. The optical module according to claim 3, wherein said optical element (16) is fixed to one surface of said sheet-shaped carrier and said current control section is fixed to another surface of said sheet-shaped carrier, a recess section (46) is provided in said holding member (42), and said sheet-shaped carrier (44) is held by said holding member such that said current control section is accommodated in said recess section.

7. The optical module according to claim 1, comprising an optical element sealing section (58; 72) for sealing said optical element.

8. The optical module according to claim 7, wherein said optical element sealing section is formed by transfer moulding using transparent resin.

9. The optical module according to claim 8, wherein a recess (74) for inserting the end of an optical fiber (76) is provided in said optical element sealing section (72).

10. The optical module according to claim 9, wherein the lower surface (74a) of said recess is provided with a shape and dimensions corresponding to the end of an optical fiber (76).

11. The optical module according to claim 1, comprising a current control section sealing section (60) for sealing said current control section.

12. The optical module according to claim 1, wherein said optical element is a light receiving element, and said current control section is an amplifier.

13. The optical module according to claim 1 , wherein said optical element is a light-emitting element, and said current control section is a driver IC.

14. The optical module according to claim 1, wherein said holding section is a plate-shaped member (182; 202), said first surface is one side (182a; 202a) of said plate-shaped member, said second surface is the upper surface (182b; 202b) of said plate-shaped member, and said current control section (186) is incorporated in the upper surface of said plate-shaped member.

15. The optical module according to claim 14, wherein said one side (182a; 202a) is a plane angled obliquely with respect to the plane intersecting perpendicularly with the lower surface (182c; 202c) of said plate-shaped member.

16. The optical module according to claim 15, wherein said plate-shaped member is a silicon wafer, and said obliquely angled surface is a plane formed along a crystal surface of the silicon wafer.

17. The optical module according to claim 14, wherein said optical element is a light receiving element (184; 204), and said current control section is an amplifier (186; 206).

18. The optical module according to claim 14, wherein said optical element is a light-emitting element (184; 204), and said current control section is a driver IC.

19. The optical module according to claim 1, wherein said holding section is a plate-shaped member (222; 232), said first surface is one side (222a; 232a) of said plate-shaped member, said second surface is the upper surface (222b; 232b) of said plate-shaped member, and said current control section (206) is mounted directly on the upper surface of said plate-shaped member.

20. The optical module according to claim 19, wherein a recess section (224) capable of accommodating said current control section (206) is formed in said upper surface, and said current control section is positioned in said recess section.

21. The optical module according to claim 20, wherein said one side (222a; 232a) is a surface angled obliquely with respect to the plane intersecting perpendicularly with the lower surface of said plate-shaped holding member (222; 232).

22. The optical module according to claim 21, wherein said plate-shaped member comprises, internally, a capacitor (236) for preventing oscillation of said optical element.

23. The optical module according to claim 19, wherein said optical element is a light receiving element (204), and said current control section is an amplifier (206).

24. The optical module according to claim 19, wherein said optical element is a light-emitting element, and said current control section is a driver IC.

25. An optical module (80; 100; 120; 140; 160) comprising:
an optical element (16; 106; 126; 146; 164);
a current control section (18; 104; 124; 144; 162); and
a holding member (82; 102; 122, 128; 142) for holding said optical element and said current control section,
wherein said current control section is provided on said holding member and said optical element is provided on the upperside or active area side surface (18a; 122a) of said current control section.

26. The optical module according to claim 25, wherein said optical element (106) is bonded to said current control section (104) by means of bumps (107; 127; 148; 166).

27. The optical module according to claim 25, wherein said holding member comprises a metal plate, and said current control section is provided on said metal plate.

28. The optical module according to claim 25, wherein a first step section (128a; 142c) is formed by said holding member (128), further comprising a casing (132; 149) having an opening (132a; 149a) wherein a second step section (132b; 149b) of a complementary shape to said first step section is provided around the perimeter of said opening.

29. The optical module according to claims 25, further comprising a covering section (128) for covering said optical element and current control section.

30. The optical module according to claim 29, wherein a first coupling section (128a) is formed by said covering section (128), further comprising a casing (132) having an opening (132a) wherein a second coupling section (132b) of a complementary shape to said first coupling section is provided around the perimeter of said opening.

31. The optical module according to claim 25, wherein said optical element is an optical element (126) comprising a light-receiving section or light-emitting section on an end surface thereof, and a groove (168) for accommodating the end portion of an optical fiber (170) is formed on the upperside or active area side surface of said current control section (162).

32. The optical module according to claim 31, wherein said groove has a V-shaped cross-section.

33. The optical module according to claim 25, wherein said optical element is a light receiving element, and said current control section is an amplifier.

34. The optical module according to claim 25, wherein said optical element is a light-emitting element, and said current control section is a driver IC.
